(19) **Europäisches Patentamt**

**European Patent Office**

**Office européen des brevets**

(11) **EP 0 916 958 B1**

(12) **FASCICULE DE BREVET EUROPEEN**

(45) Date de publication et mention
de la délivrance du brevet:
**26.09.2001 Bulletin 2001/39**

(51) Int Cl.$^7$: **G01R 31/315**, G01R 31/04

(21) Numéro de dépôt: **98121545.2**

(22) Date de dépôt: **17.11.1998**

(54) **Procédé de test d'un circuit résonant inductif**

Verfahren zum Prüfen einer induktiven Resonanzschaltung

Method for the testing of an inductive resonant circuit

(84) Etats contractants désignés:
**DE FR GB IT**

(30) Priorité: **18.11.1997 FR 9714687**

(43) Date de publication de la demande:
**19.05.1999 Bulletin 1999/20**

(73) Titulaire: **STMicroelectronics SA
94250 Gentilly Cedex (FR)**

(72) Inventeur: **Enguent, Jean-Pierre
13119 Saint Savournin (FR)**

(74) Mandataire: **Ballot, Paul Denis Jacques
Cabinet Ballot
9, boulevard de Strasbourg
83000 Toulon (FR)**

(56) Documents cités:
**US-A- 4 392 106**     **US-A- 5 631 572**

• **PATENT ABSTRACTS OF JAPAN vol. 018, no. 272 (M-1610), 24 mai 1994 & JP 06 047513 A (SUMITOMO LIGHT METAL IND LTD), 22 février 1994**

# Description

La présente invention concerne un procédé et un système de test d'un circuit résonant comprenant une capacité et une bobine.

La présente invention concerne notamment le test des circuits d'antenne des objets portatifs fonctionnant sans contact comme les cartes à puces sans contact, les étiquettes électroniques,...

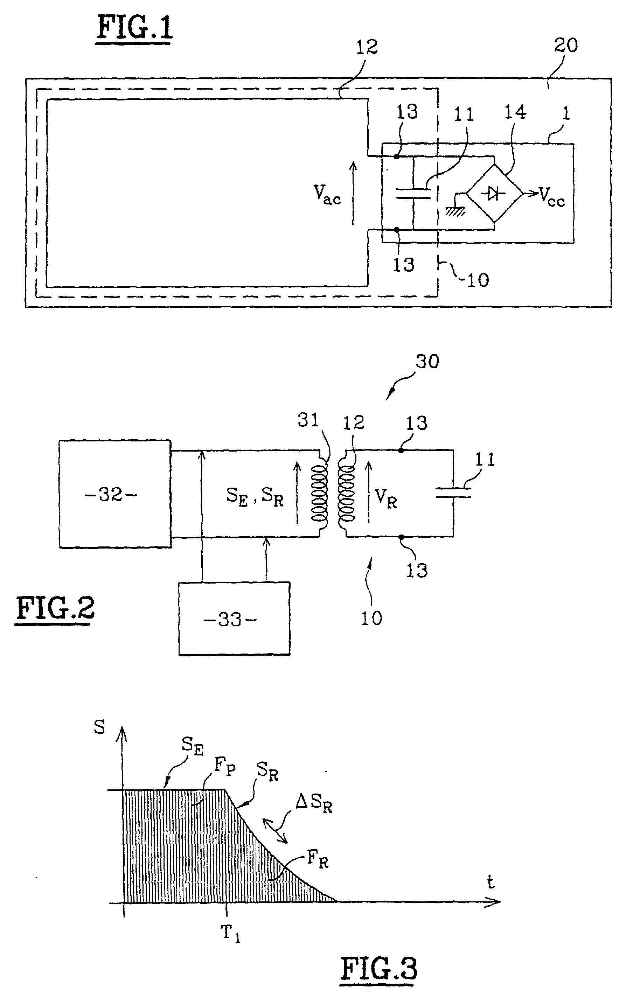

A titre de rappel la figure 1 représente très schématiquement un circuit intégré 1 fonctionnant sans contact, agencé par exemple sur une carte plastique 20 pour former une carte à puce sans contact. Ce circuit intégré 1 est pourvu d'un circuit d'antenne 10 comprenant essentiellement une capacité 11 intégrée dans le silicium du circuit 1 et une bobine d'antenne 12. La bobine 12 est agencée sur la carte plastique 20 et est connectée aux bornes de la capacité 11 grâce à des plots de connexion 13, par soudure à l'étain/plomb ou câblage aux ultrasons. Le circuit d'antenne 10 est un circuit résonant dont la fréquence de résonance nominale Fp est généralement de 13,56 MHz selon les normes en vigueur. Lorsque la bobine 12 est plongée dans un champ magnétique alternatif calé sur la fréquence Fp, une tension alternative Vac apparaît à ses bornes par induction électromagnétique. Cette tension alternative Vac peut atteindre les 20 à 40 Volts dans de bonnes conditions de fonctionnement et est transformée par un redresseur 14 en une tension continue Vcc d'alimentation du circuit intégré.

En général, la bobine d'antenne 12 n'est connectée aux plots 13 du circuit intégré 1 qu'à un stade avancé de la fabrication, lorsque le circuit 1 est monté sur la carte plastique 20. Le circuit intégré 1 est ensuite recouvert d'une résine de protection. A ce stade, et malgré les divers contrôles ayant pu être prévus au cours des étapes précédentes, il arrive que la connexion de la bobine d'antenne 12 soit défaillante, ou que la capacité intégrée 11 ne présente pas sa valeur nominale suite, par exemple, à une dérive du procédé de fabrication du circuit intégré. Il est donc souhaitable de détecter ces anomalies.

Le document US-5,631,572 décrit un procédé de test des connexions, par contact ou par soudure, entre les pistes d'un circuit imprimé et les pattes d'un composant ou circuit intégré implanté dessus.

Le test consiste à :

- polariser chaque piste du circuit imprimé pour former une boucle de circuit entre la piste et le plan de masse du circuit imprisé, en polarisant la diode parasite qui existe entre la patte du circuit intégré connectée à la piste et le plan de masse,
- appliquer un champ électromagnétique alternatif auprès de cette boucle de circuit, et
- détecter en même temps la tension alternative induite sur la borne de polarisation en contact avec la piste pour vérifier l'intégrité de la connexion entre la piste du circuit imprimé et la patte du composant.

Ce document n'est donc pas utile à l'intelligence des problèmes de tests des circuits d'antennes de dispositifs sans contact.

Ainsi, la présente invention a pour objectif de prévoir une méthode de test permettant de déterminer si le circuit d'antenne d'une carte à puce sans contact, et plus généralement d'un objet portatif électronique sans contact, n'est pas défectueux.

De façon plus générale, la présente invention à pour objectif de permettre le contrôle non visuel d'un circuit résonant inductif.

Pour atteindre cet objectif, la présente invention repose sur l'idée simple mais non moins inventive d'exciter le circuit résonant par couplage inductif, puis d'observer, toujours par couplage inductif, la réaction du circuit résonant.

Plus particulièrement, la présente invention prévoit un procédé de test d'un circuit résonant inductif comprenant une capacité et une bobine d'antenne, comprenant les étapes consistant à exciter le circuit résonant par couplage inductif au moyen d'une bobine de test agencée à proximité de la bobine du circuit résonant, interrompre brutalement l'excitation du circuit résonant, puis détecter dans la bobine de test un signal de réponse engendré par auto-induction dans la bobine du circuit résonant et retransmis à la bobine de test par couplage inductif.

De préférence, on excite le circuit résonant en appliquant à la bobine de test un signal à la fréquence de résonance présumée du circuit résonant.

En pratique, la période d'excitation du circuit résonant peut être courte et inférieure à la seconde.

Si aucun signal de réponse n'est détecté, le circuit résonant peut être considéré comme étant hors service.

Dans le cas contraire, le signal de réponse peut être analysé de manière à déterminer sa vitesse de décroissance.

Quand la vitesse de décroissance du signal de réponse est supérieure à un seuil prédéterminé, le circuit résonant peut être considéré comme étant hors service.

Egalement, le signal de réponse peut être analysé de manière à déterminer sa fréquence d'oscillation.

Quand la fréquence d'oscillation du signal de réponse est sensiblement différente de la fréquence de résonance présumée, le circuit résonant peut être considéré comme étant hors service.

Ces divers aspects de l'invention, ainsi que d'autres, seront exposés plus en détail dans la description suivante du procédé de test selon l'invention en relation avec les figures jointes parmi lesquelles :

- la figure 1 précédemment décrite représente le circuit d'antenne d'un objet portatif électronique fonctionnant sans contact,

- la figure 2 représente un montage de test permettant de mettre en oeuvre le procédé de l'invention, et

- la figure 3 est une courbe en fonction du temps d'un signal de test selon l'invention.

La figure 2 représente un système de test 30 permettant de mettre en oeuvre le procédé selon l'invention. Ce système 30 comprend essentiellement une bobine de test 31, un générateur de signaux 32 et un appareil de mesure 33. La bobine de test 31 est connectée à la sortie du générateur de signaux 32 et l'appareil de mesure 33 est connecté aux bornes de la bobine test 31. A proximité de la bobine de test 31 est disposée la bobine 12 d'un circuit d'antenne 10 du type décrit au préambule, comprenant la capacité silicium 11 d'un circuit intégré fonctionnant sans contact.

Au cours d'une première étape de durée T1, on excite la bobine de test 31 au moyen d'un signal $S_E$ (tension ou courant) afin de transmettre et d'accumuler dans la bobine d'antenne 12 de l'énergie inductive. Le signal $S_E$ est de préférence alternatif et calé sur la fréquence de résonance présumée Fp du circuit d'antenne 10, soit 13,56 MHz selon les normes en vigueur. Pour fixer les idées, la figure 3 représente la forme du signal $S_E$. La période T1 d'application du signal d'excitation peut être courte et inférieure à la seconde, par exemple de l'ordre de la centaine de millisecondes.

Au cours d'une deuxième étape, on interrompt brutalement le signal d'excitation $S_E$ et l'on observe au moyen de l'appareil de mesure 33 un signal de réponse $S_R$ apparaissant aux bornes de la bobine de test 31. Ce signal de réponse $S_R$ (pouvant être observé en tension ou en courant) est l'image d'une tension de réaction $V_R$ apparaissant par auto-induction dans la bobine d'antenne 12 suite à l'interruption brutale du signal d'excitation $S_E$. Comme le montre la figure 3, le signal de réponse $S_R$ est décroissant et alternatif. Sa vitesse de décroissance $\Delta S_R$ en fonction du temps est représentative de la résistance série du circuit d'antenne 10. Sa fréquence d'oscillation $F_R$ est la fréquence propre du circuit d'antenne, soit :

$$F_R = [2\Pi\sqrt{LC}]^{-1}$$

C étant la valeur de la capacité 11 et L l'inductance de la bobine d'antenne 12.

Avantageusement, l'observation du signal de réponse $S_R$ et la mesure des paramètres $\Delta S_R$ et $F_R$ permettent de vérifier la conformité du circuit d'antenne 10 relativement à des normes de qualité prédéterminées. En particulier, la vitesse de décroissance $\Delta S_R$ est considérée comme acceptable si elle est inférieure à une valeur de seuil $\Delta S_{R0}$. Egalement, la fréquence propre $F_R$ est considérée comme acceptable si elle est sensiblement égale, dans un domaine de tolérance déterminé (par exemple à 20% près), à la fréquence nominale Fp souhaitée.

En pratique, quatre cas peuvent ainsi être observés :

1) La vitesse de décroissance $\Delta S_R$ est inférieure au seuil $\Delta S_{R0}$ et la fréquence $F_R$ est sensiblement égale à la fréquence nominale Fp (dans le domaine de tolérance). Le circuit d'antenne 10 est considéré comme bon et le dispositif portable pourvu de ce circuit d'antenne peut être commercialisé.

2) Aucun signal de réponse n'est détecté. Dans ce cas, le circuit d'antenne 10 est en circuit ouvert et ne fonctionne pas. Cela est généralement le cas quand la soudure de la bobine d'antenne 12 aux plots de connexion 13 est défectueuse. Le test selon l'invention intervenant généralement en phase finale de production, l'objet portable comportant un tel circuit d'antenne sera généralement mis au rebut.

3) La fréquence $F_R$ est sensiblement égale à la fréquence nominale Fp mais la vitesse de décroissance $\Delta S_R$ est supérieure au seuil $\Delta S_{R0}$. Cela signifie que le circuit d'antenne 10 présente un facteur d'amortissement trop important en raisons de résistances parasites autres que la résistance série de la bobine d'antenne 12 et la résistance intrinsèque de la capacité silicium 11, qui sont prises en compte pour la détermination du seuil $\Delta S_{R0}$. En général, la cause de cette anomalie est que la soudure de la bobine aux plots 13 est défaillante (par exemple une soudure "sèche" à l'étain-plomb ou une soudure aux ultrasons ayant mal adhéré) et présente une résistance série élevée. Le circuit d'antenne 10 est alors considéré comme hors service et l'objet portable mis au rebut.

4) La vitesse de décroissance $\Delta S_R$ est inférieure au seuil $\Delta S_{R0}$ mais la fréquence $F_R$ est sensiblement différente de la fréquence nominale Fp (c'est-à-dire en dehors du domaine de tolérance). Cela signifie que la capacité intégrée 11 n'est pas à sa valeur normale prévue par construction. Si cette anomalie est constatée sur plusieurs circuits d'antenne, cela signifie que procédé de fabrication de la capacité 11 subit une dérive et que des actions correctives doivent être prévues. En tout état de cause, ce circuit d'antenne 10 peut être considéré comme hors service. En effet, un circuit d'antenne 10 désaccordé délivre en présence d'un champ magnétique une tension induite Va trop faible pour assurer l'alimentation électrique d'un circuit intégré sans contact.

En définitive, la présente invention offre un procédé simple et pratique permettant de savoir si les caractéristiques d'un circuit résonant inductif entrent dans un domaine de tolérances.

En outre, le procédé selon l'invention ne nécessite aucun contrôle visuel et se prête bien à une automatisation dans une chaîne de production. Par exemple, on prévoit, selon un mode de réalisation, que des cartes à puce sans contact soient transportées par un moyen de convoyage devant un poste de test du type représenté en figure 2. L'arrivée de chaque carte est détectée par une cellule photoélectrique qui déclenche l'envoi du signal d'excitation $S_E$ et l'analyse du signal de réponse $S_R$. Pour assurer un bon couplage inductif avec les bobines d'antenne des cartes à puce, la bobine de test 12 est de préférence plate et est disposée au dessus ou au dessous du moyen de convoyage, à une distance de quelques millimètres de celui-ci.

Enfin, on a proposé dans ce qui précède d'exciter le circuit d'antenne 10 au moyen d'un signal $S_E$ calé sur la fréquence de résonance présumée Fp. L'avantage de cette méthode est d'envoyer le maximum d'énergie inductive dans la bobine 12 en un temps très court. Il entre toutefois dans le cadre de la présente invention de prévoir un autre type de signal d'excitation, par exemple un signal non oscillant en forme de créneau. Bien qu'un tel signal offre une moindre efficacité, il peut permettre de tester des circuits d'antenne ayant des fréquences de résonance différentes ou dont la fréquence de résonance n'est pas a priori connue.

**Revendications**

1.　Procédé de test d'un circuit résonant (10) comprenant une capacité (11) et une bobine (12), **caractérisé en ce qu'**il comprend des étapes consistant à :

-　exciter le circuit résonant (10) par couplage inductif au moyen d'une bobine de test (31) agencée à proximité de la bobine (12) du circuit résonant (10),
-　interrompre brutalement l'excitation du circuit résonant (10), puis
-　détecter dans la bobine de test (31) un signal de réponse ($S_R$) engendré par auto-induction dans la bobine (12) du circuit résonant (10) et retransmis à la bobine de test (31) par couplage inductif.

2.　Procédé selon la revendication 1, dans lequel on excite le circuit résonant (10) en appliquant à la bobine de test (31) un signal à la fréquence de résonance (Fp) présumée du circuit résonant.

3.　Procédé selon l'une des revendications 1 et 2 dans lequel le circuit résonant (10) est considéré comme étant hors service lorsqu'aucun signal de réponse ($S_R$) n'est détecté.

4.　Procédé selon l'une des revendications précédentes, dans lequel le signal de réponse ($S_R$) est analysé de manière à déterminer sa vitesse de décroissance ($\Delta S_R$).

5.　Procédé selon la revendication 4 dans lequel, le circuit résonant (10) est considéré comme étant hors service quand la vitesse de décroissance ($\Delta S_R$) du signal de réponse ($S_R$) est supérieure à un seuil prédéterminé ($\Delta S_{R0}$).

6.　Procédé selon l'une des revendications précédentes, dans lequel le signal de réponse ($S_R$) est analysé de manière à déterminer sa fréquence d'oscillation ($F_R$).

7.　Procédé selon la revendication 6 dans lequel le circuit résonant (10) est considéré comme étant hors service quand la fréquence d'oscillation ($F_R$) du signal de réponse ($S_R$) est sensiblement différente de la fréquence de résonance présumée (Fp).

8.　Procédé selon l'une des revendications précédentes, dans lequel la période (T1) d'excitation du circuit résonant (10) est très courte et inférieure à la seconde.

9.　Procédé selon l'une des revendications précédentes, dans lequel on utilise un circuit d'antenne d'un objet portatif électronique (20), pour sa mise en oeuvre en tant que circuit résonant (10).

10.　Procédé selon l'une des revendications précédentes, dans lequel on utilise une bobine de test de forme plate.

**Patentansprüche**

1.　Verfahren zum Prüfen einer Resonanzschaltung (10) mit einer Kapazität (11) und einer Spule (12), **dadurch gekennzeichnet, dass** es die folgenden Schritte aufweist:

-　Anregen der Resonanzschaltung (10) durch induktive Kopplung mittels einer in der Nähe der Spule (12) der Resonanzschaltung (10) angeordneten Prüfspule (31),
-　abruptes Unterbrechen der Anregung der Resonanzschaltung (10) und
-　Feststellen eines durch Selbstinduktion in der Spule (12) der Resonanzschaltung (10) erzeugten und durch induktive Kopplung an die Prüfspule zurückübertragenen Antwortsignals ($S_R$) in der Prüfspule (31).

2.　Verfahren nach Anspruch 1, bei dem die Resonanzschaltung (10) durch Anlegen eines Signals mit der vermuteten Resonanzfrequenz ($F_P$) der Resonanzschaltung an die Prüfspule (31) angeregt wird.

3.　Verfahren nach einem der Ansprüche 1 oder 2, bei dem die Resonanzschaltung (10) als außer Betrieb betrachtet wird, wenn kein Antwortsignal ($S_R$) festgestellt wird.

4. Verfahren nach einem der vorhergehenden Ansprüche, bei dem die Abklinggeschwindigkeit ($\Delta S_R$) des Antwortsignals ($S_R$) analysiert wird.

5. Verfahren nach Anspruch 4, bei dem die Resonanzschaltung (10) als außer Betrieb betrachtet wird, wenn die Abklinggeschwindigkeit ($\Delta S_R$) des Antwortsignals ($S_R$) größer als eine vorbestimmte Schwelle ($\Delta S_{R0}$) ist.

6. Verfahren nach einem der vorhergehenden Ansprüche, bei dem die Schwingfrequenz ($F_R$) des Antwortsignals ($S_R$) analysiert wird.

7. Verfahren nach Anspruch 6, bei dem die Resonanzschaltung (10) als außer Betrieb betrachtet wird, wenn sich die Schwingfrequenz ($F_R$) des Antwortsignals ($S_R$) stark von der vermuteten Resonanzfrequenz ($F_P$) unterscheidet.

8. Verfahren nach einem der vorhergehenden Ansprüche, bei dem die Dauer (T1) der Anregung der Resonanzschaltung (10) sehr kurz ist und kleiner als die zweite Dauer.

9. Verfahren nach einem der vorhergehenden Ansprüche, bei dem ein Antennenkreis einer elektronischen tragbaren Einrichtung (20) verwendet wird, um ihn als Resonanzschaltung (10) einzusetzen.

10. Verfahren nach einem der vorhergehenden Ansprüche, bei dem eine Prüfspule von flacher Form verwendet wird.

**Claims**

1. Method for testing a resonant circuit (10) comprising a capacitor (11) and a coil (12), **characterised in that** it comprises steps consisting in :

   - exciting the resonant circuit (10) by inductive coupling by means of a test coil (31) positioned in the vicinity of the coil (12) of the resonant circuit (10),
   - sharply interrupting the excitation of the resonant circuit (10) and then,
   - detecting, in the test coil (31), a response signal ($S_R$) generated by self-induction in the coil (12) of the resonant circuit (10) and retransmitted to the test coil (31) by inductive coupling.

2. Method according to claim 1, wherein the resonant circuit (10) is excited by the application, to the test coil (31), of a signal at the presumed resonance frequency (Fp) of the resonant circuit.

3. Method according to either of the claims 1 or 2, wherein the resonant circuit (10) is considered to be out of operation when no response signal ($S_R$) is detected.

4. Method according to one of the above claims, wherein the response signal ($S_R$) is analyzed so as to determine its speed of decrease ($\Delta S_R$).

5. Method according to claim 4, wherein the resonant circuit (10) is considered to be out of operation when the speed of decrease ($\Delta S_R$) of the response signal ($S_R$) is above a predetermined threshold ($\Delta S_{R0}$).

6. Method according to one of the above claims, wherein the response signal ($S_R$) is analyzed so as to determine its oscillation frequency ($F_R$).

7. Method according to claim 6, wherein the resonant circuit (10) is considered to be out of operation when the oscillation frequency ($F_R$) of the response signal ($S_R$) is substantially different from the presumed resonance frequency ($F_P$).

8. Method according to one of the above claims, wherein the period (T1) of excitation of the resonant circuit (10) is very short and smaller than one second.

9. Method according to one the above claims, wherein an antenna circuit of an electronic portable object (20) is used as the resonant circuit (10).

10. Method according to one of the above claims, wherein a flat test coil is used.

## FIG.1

$V_{ac}$

$V_{cc}$

12    20    13    11    14    1    13    10

## FIG.2

30

31   12   13

-32-

$S_E, S_R$

$V_R$

11

-33-

10   13

## FIG.3

S

$S_E$   $F_P$   $S_R$   $\Delta S_R$

$F_R$

t

$T_1$